# EUROPEAN PATENT APPLICATION

(11) **EP 1 686 631 A2**
(43) Date of publication of application: **02.08.2006**
(21) Application number: 06001880.1
(22) Date of filing: 30.01.2006
(51) Int. Cl.: H01L 33/00

(54) **Light-emitting diode apparatus**

(30) Priority: 31.01.2005 JP 2005024165
(71) Applicant: Toshiba Lighting & Technology Corporation, Shinagawa-ku, Tokyo (JP)
(72) Inventor: Toda, Masahiro, 4-3-1 Higashi-Shinagawa Shinagawa Tokyo (JP); Iwamoto, Masami, 4-3-1 Higashi-Shinagawa Shinagawa Tokyo (JP); Moriyama, Takayoshi, 4-3-1 Higashi-Shinagawa Shinagawa Tokyo (JP); Nakanishi, Akiko, 4-3-1 Higashi-Shinagawa Shinagawa Tokyo (JP); Saito, Akiko, 4-3-1 Higashi-Shinagawa Shinagawa Tokyo (JP); Kawashima, Seiko, 4-3-1 Higashi-Shinagawa Shinagawa Tokyo (JP); Sanpei, Tomohiro, 4-3-1 Higashi-Shinagawa Shinagawa Tokyo (JP); Shiozaki, Mitsuru, 4-3-1 Higashi-Shinagawa Shinagawa Tokyo (JP); Uetake, Hisayo, 4-3-1 Higashi-Shinagawa Shinagawa Tokyo (JP)
(74) Representative: Kramer - Barske - Schmidtchen

(57) **Abstract**

A light-emitting diode lighting apparatus includes a plurality of light-emitting diode apparatus arranged on a substrate. Each of the light-emitting diode apparatus is provided with a light-emitting diode chip mounted on a substrate, a phosphor layer coating the light-emitting diode chip, and a reflective layer, disposed on the substrate, having reflection characteristics in which a reflectance for light in a wavelength range of light emission from the light-emitting diode chip is lower than a reflectance of nickel and the reflectance for light in the wavelength range of fluorescence emission from the phosphor layer is higher than the reflectance of nickel.

## Description

### BACKGROUND OF THE INVENTION

### Field of the Invention

The present invention relates to a light-emitting diode apparatus or equipment provided with a light emitting diode (LED).

### Related Art

Conventionally, there is provided a surface-mounting type light-emitting diode apparatus, in which a synthetic resin is filled in a case equipped with a light-emitting diode chip to encapsulate the chip as disclosed in Japanese Patent Laid-open Publication No. 2002-43625 (JP 2002-43625A). There is also known one conventional example of a light-emitting diode apparatus which outputs white light resulting from color mixing of the blue light from a blue-emitting LED chip and yellow light produced by exciting a yellow-emitting phosphor by the blue emission. Furthermore, in the known light-emitting diode apparatus of this type, a white resin having a high reflectance or metal plating, e.g., Ag plating or Ni plating, is disposed on a mounting surface of a substrate in order that light emission from a light-emitting diode chip is reflected by the resulting mounting surface of the substrate so as to enhance a light flux of output light, for example, as disclosed in Japanese Patent Laid-open Publication No. 2002-319711 (JP 2002-319711A).

However, in the known technology mentioned above, when the silver plating having a reflectance higher that of the nickel plating is used in order to enhance the light flux of output light, although the light flux of the output light is improved, a color rendering property and a correlated color temperature are varied, thus being inconvenience and disadvantageous.

This is because, in the conventional technology, when the reflectance on the short-wavelength side, i.e., blue emission (for example, 460 nm) from a light-emitting diode chip, is increased, the emission intensity of a phosphor allowed to emit light by the blue emission is increased and, thereby, the intensity ratio relative to the blue-emission intensity varies.

Therefore, it cannot be always realized and is not reasonable to enhance both the light flux of output light and the color rendering by increasing the reflectance.

### SUMMARY OF THE INVENTION

Accordingly, an object of the present invention is to substantially eliminate defects or drawbacks encountered in the prior art mentioned above and is to provide a light-emitting diode apparatus capable of suppressing deterioration of color rendering and enhancing a light flux of an output light.

The above and other objects can be achieved according to the present invention by providing, in one aspect, a light-emitting diode apparatus provided with a light-emitting diode chip mounted on a substrate, a phosphor layer coating the light-emitting diode chip, and a reflective layer, disposed on the substrate, having reflection characteristics in which a reflectance for light in a wavelength range of light emission from the light-emitting diode chip is lower than a reflectance of nickel and the reflectance for light in the wavelength range of fluorescence emission from the phosphor layer is higher than the reflectance of nickel.

In the light-emitting diode apparatus of this aspect, the reflective layer may be formed from gold.

The reflective layer may have a flood opening to project light from the phosphor layer and be disposed on an inner surface of a concave portion to accommodate the light-emitting diode chip.

In another aspect of the present invention, there is also provided a light-emitting diode apparatus provided with a light-emitting diode chip which is mounted on a substrate and emits primarily blue light, a phosphor layer which emits yellow based light by being excited by the blue light from the light-emitting diode chip and radiates white light resulting from color mixing of the blue light and the yellow based light, and a reflective layer having characteristics, in which a reflectance at a wavelength of 540 nm is 1.3 to 2.5 times larger than a reflectance at a wavelength of 460 nm and the reflectance at a wavelength of 540 nm is 70% or more and reflecting at least the blue light and the yellow based light.

In this aspect, the reflective layer may also have a flood opening to project light from the phosphor layer and be disposed on an inner surface of a concave portion to accommodate the light-emitting diode chip.

The reflective layer may be formed from gold plating.

It may be desired that the gold plating layer has a thickness of 0.2 to 0.4 µm.

The reflective layer may be disposed on the substrate.

In a further aspect of the present invention, there may be provided a light-emitting diode lighting equipment comprising a substrate and a plurality of light-emitting diode apparatus arranged on the substrate in a predetermined matrix, each of the light-emitting diode apparatus comprising a light-emitting diode chip mounted on a substrate, a phosphor layer coating the light-emitting diode chip and containing a phosphor, and a reflective layer disposed on the substrate and having reflection characteristics in which a reflectance for light in a wavelength range of light emission from the light-emitting diode chip is lower than a reflectance of nickel and the reflectance for light in the wavelength range of fluorescence emission from the phosphor layer is higher than the reflectance of nickel.

According to the first aspect, since the reflectance for light in a long wavelength range including fluorescence emission from the phosphor layer can be made higher than the reflectance of Ni, the light flux of the output light output from this phosphor layer to the outside can be enhanced correspondingly.

Furthermore, since the output light having enhanced light flux is the light in a long wavelength range suitable for improving the color rendering, deterioration of the color rendering can be suppressed.

In addition, when the reflective layer is formed from gold, deterioration with time elapse due to the oxidation or sulfuration of the reflective layer can be prevented or reduced.

Furthermore, when the light in a long wavelength range from the phosphor is reflected with high reflectances at two places, a reflective surface of the substrate and an inner surface of the concave portion having the flood opening, the amount of reflected light can be increased. Therefore, according to the increasing of the amount of reflected light, the light flux of output light output from the opening of the concave portion to the outside can be enhanced correspondingly.

According to the second aspect, since the luminous efficiency (Im/W) in a low correlated color temperature range of, for example, about 7,000 K or lower can be improved by the reflective layer thereof as compared with the luminous efficiency of Ni reflective layer and the like, a reduction in the output of light in the low correlated color temperature range can be suppressed correspondingly. In addition, the correlated color temperature can be changed appropriately by, for example, a method in which the composition and the like of the phosphor layer is changed while a reduction in the output of light is suppressed in the low correlated color temperature range.

If the ratio of the reflectance at the 540 nm to that at 460 nm of the reflective layer is less than 1.3, the reflection characteristics get closer to the reflection characteristics of nickel in which the reflectance for the light in a short wavelength range is higher than that of gold and, thereby, it becomes hard to adjust at a low correlated color temperature. If the ratio of the reflectances exceeds 2.5 times, the blue light in the reflected light is reduced relatively and, thereby, the luminous efficiency tends to be reduced. Consequently, adjustment can be conducted only in the low correlated color temperature range, and the adjustable range of correlated color temperature becomes narrow.

Furthermore, when the reflective layer is formed from gold plating, deterioration with time elapse due to the oxidation or sulfuration of the reflective layer can be prevented or reduced.

In the case of the thickness of the reflective layer formed from gold plating of 0.2 to 0.4 µm, the higher reflectance than the reflectance in the case where the thickness is out of this range can be effectively obtained.

In addition, since the reflective layer can be disposed on a planar substrate when the light-emitting diode chip is mounted on the substrate, this reflective layer can easily be formed with a high degree of efficiency and a high degree of precision.

Furthermore, after the light-emitting diode chip is mounted on the substrate, the substrate serves as a bottom surface and a light output hole (flood opening) can easily be formed while facing this bottom surface linearly. Therefore, the light output efficiency from the light output hole of the light including the light reflected by the reflective layer on the bottom surface can be improved.

The nature and further characteristic features of the present invention will be made more clear from the following descriptions made with reference to the accompanying drawings.

### BRIEF DESCRIPTION OF THE DRAWINGS

In the accompanying drawings:
Fig. 1 is an illustrated plan view of a light-emitting diode lighting apparatus or equipment according to a first embodiment of the present invention;
Fig. 2 is a sectional view taken along the line II-II in Fig. 1;
Fig. 3 is a view of a portion III, in an enlarged scale, shown in Fig. 2;
Fig. 4 is a view, also in an enlarged scale, of a portion corresponding to Fig. 3in another embodiment of the present invention;
Fig. 5 is a graph in comparison of visible light reflection characteristics between that of bottom and side-surface gold plating layers and that of a known Ni plating layer;
Fig. 6 is a vertical sectional view showing an essential portion of a light-emitting diode apparatus in a light-emitting diode lighting equipment according to a second embodiment of the present invention;
Fig. 7 is a table showing a correlation between thickness of the gold plating layer shown in Fig. 6 and the total reflectance for white light at a required wavelength;
Fig. 8 is a graph representing a correlation between thickness of the gold plating layer and the total reflectance for white light at a required wavelength shown in Fig. 7; and
Fig. 9 is a graph representing a correlation between a correlated color temperature and a luminous efficiency of white light when gold plating or nickel plating is used as a reflective layer of the light-emitting diode apparatus shown in Fig. 6.

### DESCRIPTION OF THE PREFERRED EMBODIMENT

An embodiment of the present invention will be described hereunder with reference to the accompanying drawings, in which same or corresponding components are indicated by the same reference numerals and their duplicated explanations are omitted herein.

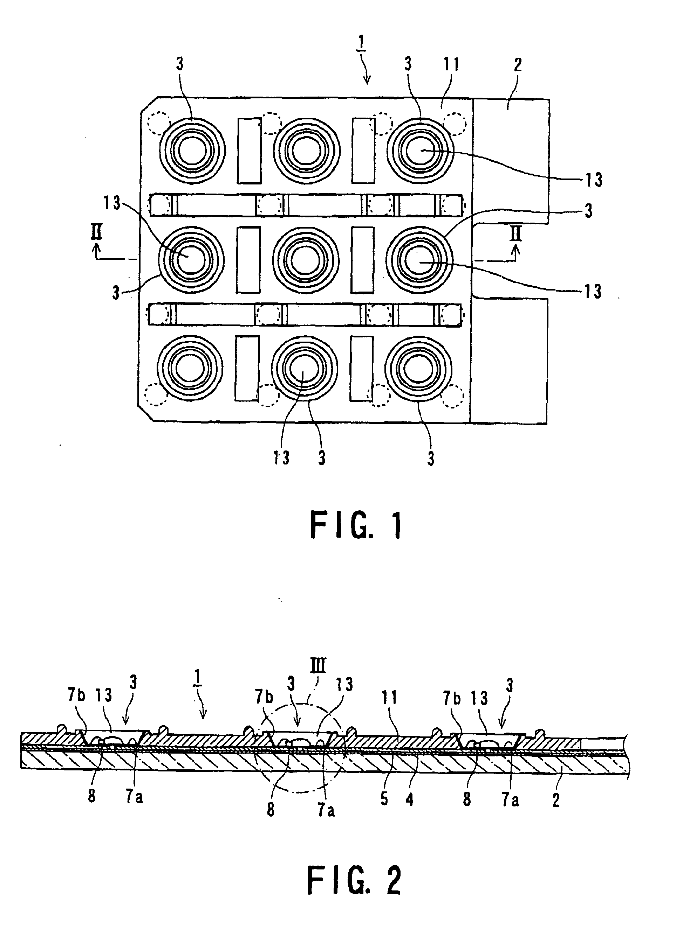

With reference to Fig. 1 and Fig. 2, a plurality of light-emitting diode apparatus 3, 3, ··· are disposed in an LED lighting equipment 1 in form of, for example, a matrix with 3 rows and 3 columns on a substrate 2, the light-emitting diode apparatus 3 being coupled integrally.

The substrate 2 is composed of a flat plate made of Al, Ni, glass epoxy or the like exhibiting a heat release effect and rigidity, and is an integrated substrate in which the respective substrates of the plurality of light-emitting diode apparatus 3, 3, ··· are coupled integrally. An electrically conductive layer 5 is disposed on this substrate 2 with an electrically insulating layer 4 therebetween.

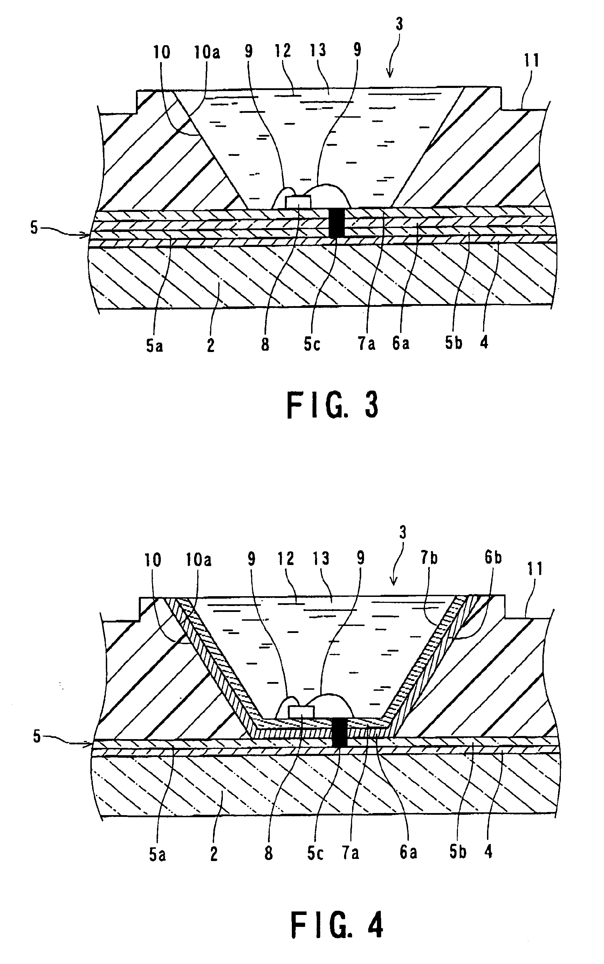

As shown in Fig. 3, the electrically conductive layer 5 is composed of a pair of circuit patterns (wiring patterns) 5a and 5b made of an alloy of Cu and Ni, Au, or the like and disposed on the negative electrode side and the positive electrode side on each LED apparatus 3.

An electrical insulator 5c made of a resin or the like is interposed between the paired circuit patterns 5a and 5b so as to electrically insulate the pair of circuit patterns 5a and 5b from each other.

A bottom gold plating layer 7a is disposed on the pair of circuit patterns 5a and 5b with a bottom Ni plating layer 6a being interposed therebetween. The bottom Ni plating layer 6a constitutes a substrate layer of the bottom gold plating layer 7a. The negative electrode side and the positive electrode side of each of the bottom Ni plating layer 6a and the bottom gold plating layer 7a are insulated from each other through the electrical insulator 5c in accordance with the pair of circuit patterns 5a and 5b.

A blue-emitting LED chip 8 is mounted on one of the negative electrode side and the positive electrode side of the bottom gold plating layer 7a on each of the LED apparatus. Each blue-emitting LED chip 8 is composed of, for example, a GaN based semiconductor or the like which emits blue light. A pair of upper surface electrodes, i.e., a negative electrode and a positive electrode, of each blue-emitting LED chip 8 are connected to their respective gold plating layer 7a on the circuit patterns 5a and 5b by means of bonding wires 9, 9.

On the substrate 2, lens holders 11 are disposed on then LED apparatus 3, each lens holder 11 having a concentrically formed concave portion 10 surrounding the blue-emitting LED chip 8 at a predetermined distance therefrom and having a shape of a truncated cone gradually diverging toward the side opposite to the substrate 2 (upward in Fig. 2 and Fig. 3), and these lens holders are disposed integrally. The lens holder 11 is made of, for example, a synthetic resin, e.g., PBT, PPA, or PC, and the concave portion 10 has a flood (or flood-lighting) opening 10a opened outside.

The inside of each of the concave portions 10 is filled up with a thermosetting transparent resin, silicon rubber or an epoxy resin having a light transmission property, as a sealing resin 12. A resin containing a required percent by mass of yellow-emitting phosphor, which emits yellow fluorescence by receiving blue emission from the blue-emitting LED chip 8, is injected into the sealing resin 12, and heat curing is conducted, so that a yellow-emitting phosphor 13 is constructed.

The yellow-emitting phosphor 13 includes an example which emits a yellow based fluorescence with a wavelength of 480 nm or more, such as, yellow light and green light. Alternatively, as shown in Fig. 4, the Ni plating layer and the gold plating layer mentioned hereinbefore may be disposed as a side-surface Ni plating layer 6b and a side-surface gold plating layer 7b all over the side surface of the concave portion 10. Furthermore, the side-surface Ni plating layer 6b and side-surface gold plating layer 7b may be integrally coupled to the bottom Ni plating layer 6a and the bottom gold plating layer 7a, respectively.

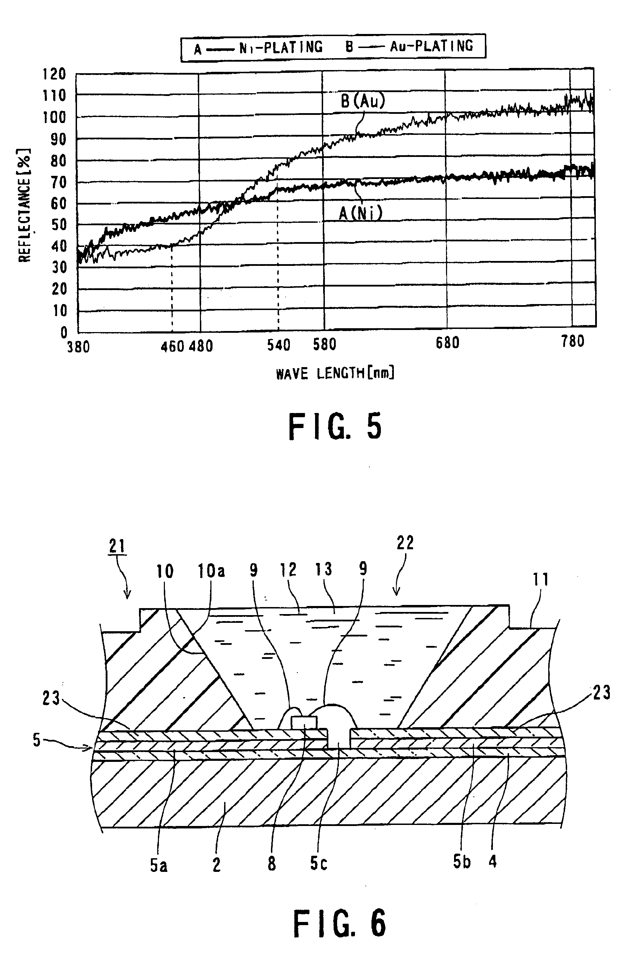

Fig. 5 represents the comparison of reflection characteristics, indicating the visible light reflectance of the bottom and side-surface gold plating layers 7a and 7b with a known one in which only a Ni plating layer is disposed and such gold plating layers 7a and 7b are not disposed.

In Fig. 5, as indicated by a curve A, for the visible light reflectance of the Ni plating layer, the reflectance in a short wavelength range of 400 nm to 480 nm including the wavelength of blue light (for example, 460 nm) from the blue-emitting LED 8 is about 50%, which is relatively high. However, the reflectance in a long wavelength range of 550 nm or more is about 65% to 70%, which is not so high.

On the other hand, as indicated by a curve B, for the visible light reflectance of the bottom and side-surface gold plating layers 7a and 7b, the reflectance in the above-described short wavelength range is, for example, about 40%, which is lower than the reflectance of the Ni plating layer of about 50%. However, the reflectance in the long wavelength range of 550 nm or more is about 80% to 100%, which is higher than the reflectance of the Ni plating layer of about 65% to 70% by about 20% to 30%.

The LED illumination apparatus 1 of the structure mentioned above will operates as follows.

When a predetermined direct current voltage is applied from the outside between each pair of the circuit patterns 5a and 5b on the negative electrode side and the positive electrode side, the blue emission of each blue-emitting LED chip 8 is effected. This blue emission excites yellow phosphor in the yellow-emitting phosphor layer 13, so that the yellow emission is effected and, in addition, white light is generated through the color mixing of this yellow and the blue. Each of the blue emission, the yellow light and the white light is reflected by the bottom gold plating layer 7a facing the flood opening 10a or is also reflected by the side-surface gold plating layer 7b gradually diverging toward the flood opening 10a, so that each of these emissions is projected from the flood opening 10a to the outside.

Consequently, the light flux of the projected light radiating from the flood opening 10a to the outside can be enhanced by, for example, about 20% to 30%.

Furthermore, the wavelength range of the light of which light flux is improved is of a long wavelength range (for example, 550 nm or more) mainly enhancing the color rendering, so that the light of this wavelength can enhance the cooler rendering. In addition, in the case where both the bottom and the side-surface gold plating layers 7a and 7b are disposed, since the light reflectance in the phosphor layer 13 is increased as compared with that in the case of disposing of only one of them, the light flux of the output light and the color rendering can be enhanced correspondingly.

Since the bottom and the side-surface gold plating layers 7a and 7b of the reflective surfaces are made of gold resistant to oxidizing, deterioration with time elapse due to the oxidation can be prevented or reduced.

Furthermore, since the bottom and the side-surface gold plating layers 7a and 7b are disposed on the electrically conductive layer 5, the substrate 2 and the lens holder 11 with the bottom and the side-surface Ni plating layers 6a and 6b serving as substrates, respectively, therebetween, the loss of gold in the bottom and the side-surface gold plating layers 7a and 7b due to the penetration into the electrically conductive layer 5, the substrate 2 and the lens holder 11 can be prevented. Therefore, the bottom and the side-surface gold plating layers 7a and 7b can applied in the improved performance. The above-described electrical insulator 5c may be substituted for the gap to mutually isolate the negative electrode side and the positive electrode side of each of the electrically conductive layer 5, the bottom Ni plating layer 6a and the bottom gold plating layer 7a.

Fig. 6 is a vertical sectional view of an essential portion of a light-emitting diode apparatus 22 disposed in a light-emitting diode lighting equipment 21 according to the second embodiment of the present invention. In Fig. 6, the same or corresponding components as in the light-emitting diode apparatus 3 shown in Fig. 1 to Fig. 4 are indicated by the same reference numerals and duplicate explanations thereof will not be provided or are made simply.

A major feature of the light-emitting diode apparatus 22 of this second embodiment resides in that a reflective layer 23 is disposed on a circuit pattern 5.

A material having reflection characteristics in which the reflectance Rb for light at 540 nm is 1.3 to 2.5 times larger than the reflectance Ra at 460 nm is used as a reflector of the reflective layer 23.

As shown in Fig. 5, the gold plating B has the reflectance Ra at 460 nm of, for example, about 40% and the reflectance Rb at 540 nm of, for example, about 80%. Since the reflectance Rb of the latter is about 2 times larger than the resistance Ra of the former, the requirement for the reflector of the reflective layer 23 is satisfied.

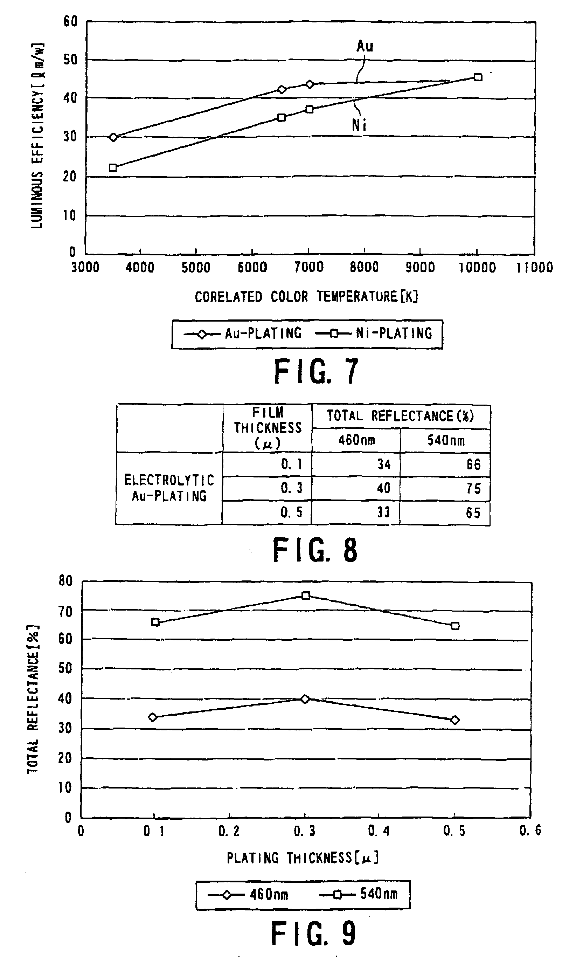

Fig. 7 is a Table showing the correlation between the thickness of this gold plating layer and the total reflectance at a required wavelength (for example, 450, 550, and 660 nm), and Fig. 8 is a graph showing the correlation. As shown in Fig. 7 and Fig. 8, the total reflectance of the gold plating layer takes on a maximum value at a plating thickness of 0.3 µm among the plating thicknesses of about 0.1 µm, 0.3 µm, and 0.5 µm.

Therefore, the gold plating layer of 0.3 µm in thickness is considered to be most desirable as the reflective layer 23.

Fig. 9 is a graph showing the correlation between the correlated color temperature (K) and the luminous efficiency when gold plating Au or nickel plating Ni is used as this reflective layer 23. This graph is based on a new finding. The correlated color temperature can be adjusted by, for example, controlling the amount of mixing of yellow light based phosphor to be mixed in a sealing resin 12, in which the yellow based light includes yellow emission, red emission and the like.

As shown in Fig. 9, in the case where the gold plating layer is used as the reflective layer 23, the luminous efficiency in a low correlated color temperature range of, for example, about 7,000 K or lower is higher than the luminous efficiency of the nickel plating layer Ni.

Therefore, in the case in which nickel is used as the reflective layer 23, the correlated color temperature can be controlled within a low temperature range by, for example, increasing the amount of mixing of the red phosphor to be mixed in the sealing resin 12. However, the red phosphor itself exhibits a low efficiency of conversion of the blue light to the red light and, in addition, the blue light from the light-emitting diode chip 8 and the yellow light from the yellow phosphor are absorbed. Consequently, the white light output is reduced.

On the other hand, in the case where the gold plating is used as the reflective layer 23, it is possible to control within a low correlated color temperature range of, for example, about 7,000 K or lower without increasing the amount of mixing of the red phosphor to be mixed in the sealing resin 12 as compared with that in the case of nickel.

Consequently, in the low correlated color temperature range, the correlated color temperature can be controlled appropriately without reducing the output light. That is, the gold plating can enhance the output light as compared with the nickel plating when the correlated color temperature of the output light to be output is equal.

Since the reflective layer 23 can be disposed on a planar substrate 2 when the light-emitting diode chip 8 is mounted on the substrate 2, this reflective layer 23 can easily be formed with a high degree of efficiency and a high degree of precision.

Furthermore, after the light-emitting diode chip 8 is mounted on the substrate 2, the substrate 2 serves as a bottom surface, and a light output hole (flood opening) can easily be formed while facing this bottom surface linearly. Therefore, the output from the light output hole of the output light including the light reflected by the reflective layer 23 on this bottom surface can be enhanced.

It is explicitly stated that all features disclosed in the description and/or the claims are intended to be disclosed separately and independently from each other for the purpose of original disclosure as well as for the purpose of restricting the claimed invention independent of the compositions of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A light-emitting diode apparatus comprising:
a light-emitting diode chip mounted on a substrate;
a phosphor layer coating the light-emitting diode chip; and
a reflective layer, disposed on the substrate, having reflection characteristics in which a reflectance for light in a wavelength range of light emission from the light-emitting diode chip is lower than a reflectance of nickel and the reflectance for light in the wavelength range of fluorescence emission from the phosphor layer is higher than the reflectance of nickel.

2. The light-emitting diode apparatus according to claim 1, wherein the reflective layer comprises gold.

3. The light-emitting diode apparatus according to claim 1 or claim 2, wherein the reflective layer has a flood opening to project light from the phosphor layer and is disposed on an inner surface of a concave portion to accommodate the light-emitting diode chip.

4. A light-emitting diode apparatus comprising:
a light-emitting diode chip which is mounted on a substrate and emits primarily blue light;
a phosphor layer which emits yellow based light by being excited by the blue light from the light-emitting diode chip and radiates white light resulting from color mixing of the blue light and the yellow based light; and
a reflective layer having characteristics in which a reflectance at a wavelength of 540 nm is 1.3 to 2.5 times larger than a reflectance at a wavelength of 460 nm and the reflectance at a wavelength of 540 nm is 70% or more and reflecting at least the blue light and the yellow based light.

5. The light-emitting diode apparatus according to claim 4, wherein the reflective layer has a flood opening to project light from the phosphor layer and is disposed on an inner surface of a concave portion to accommodate the light-emitting diode chip.

6. The light-emitting diode apparatus according to claim 4, wherein the reflective layer comprises gold plating.

7. The light-emitting diode apparatus according to claim 6, wherein the gold plating layer has a thickness of 0.2 to 0.4 µm.

8. The light-emitting diode apparatus according to any one of claims 4 to 7, wherein the reflective layer is disposed on the substrate.

9. A light-emitting diode lighting equipment comprising:
a substrate; and
a plurality of light-emitting diode apparatus arranged on the substrate in a predetermined matrix,
each of said light-emitting diode apparatus comprising:
a light-emitting diode chip mounted on a substrate;
a phosphor layer coating the light-emitting diode chip and containing a phosphor; and
a reflective layer disposed on the substrate and having reflection characteristics in which a reflectance for light in a wavelength range of light emission from the light-emitting diode chip is lower than a reflectance of nickel and the reflectance for light in the wavelength range of fluorescence emission from the phosphor layer is higher than the reflectance of nickel.
